# EUROPEAN PATENT SPECIFICATION

(11) **EP 3 523 665 B1**
(45) Date of publication and mention of the grant of the patent: **18.11.2026**
(21) Application number: 17858872.9
(22) Date of filing: 08.09.2017
(51) Int. Cl.: G01R 31/28, G01R 1/073, G01R 3/00, H05K 3/12, H05K 3/40, H05K 3/46

(54) **TEST FIXTURE**
TESTVORRICHTUNG
APPAREIL DE TEST

(30) Priority: 04.10.2016 US 201615285090
(43) Date of publication of application: 14.08.2019
(73) Proprietor: Teradyne, Inc., North Reading, MA 01864 (US)
(72) Inventor: SUTO, Anthony J., Sterling, Massachusetts 01564 (US); WRINN, Joseph Francis, Winchester, Massachusetts 01890 (US); TOSCANO, John P., Auburn, Massachusetts 01501 (US); ARENA, John Joseph, Reading, Massachusetts 01867 (US)
(74) Representative: Fish & Richardson P.C.
(86) International application number: PCT/US2017/050695
(87) International publication number: WO 2018/067267

(56) References cited:
- EP-A1- 1 906 189
- DE-A1- 102015 206 000
- US-A- 6 047 469
- US-A1- 2004 196 025
- US-A1- 2008 157 806
- US-A1- 2011 234 249
- US-A1- 2014 253 159
- US-A1- 2015 137 848
- US-A1- 2015 137 848

## Description

### TECHNICAL FIELD

This specification relates generally to a test fixture for interfacing a tester and a unit under test (UUT).

### BACKGROUND

In-circuit test (ICT) may include testing a populated printed circuit board (PCB) to determine whether the PCB was properly assembled. For example, in-circuit testing may include performing tests to identify, on the PCB, short circuits, open circuits, wrong value components, unexpected resistance, capacitance, or inductance, and so forth. A test fixture acts as an interface between the PCB and test equipment used to perform in-circuit testing.

ICT operates by gaining electrical access to a PCB test through the test fixture. When performing electrical tests, each active and passive component is typically isolated from other surrounding components and tested on an individual basis. The PCB under test is designed to support this level of testability by incorporating test pads on signal nets that can be contacted by the test fixture.

The test fixture typically provides the physical and electrical interface between an ICT system and a unit under test (UUT), such as a PCB, as described above. One of the purposes of the test fixture is to translate, geographically, test pins of a test system's receiver interface to test pad locations on the UUT. This routing of electrical signals from the test system's receiver to the UUT test pads has historically been performed using interconnect methods within the test fixture. Perhaps the most widely used interconnect method in an ICT fixture includes direct wiring from a pin connecting to the tester to a POGO pin that contacts the test pad on the UUT. This type of test fixture is called a "wired fixture". Wired fixtures are generally considered to be lower cost fixtures, especially in one-off situations or in low volume usage.

Another type of interconnect method in an ICT fixture includes use of a PCB to route signals, rather than the individual wires as in a wired fixture. The type of test fixture that uses a PCB to route signals is called a "wireless fixture". Wireless fixtures are generally more expensive to manufacture than wired fixtures and are usually deployed only in higher-volume applications, where the price of designing and building a PCB can be amortized over multiple test fixtures.

Both of the foregoing types of test fixtures have a number of common drawbacks in that the time to develop the fixtures may be too long (e.g., on the order of three to eight weeks, depending upon node count and complexity), and that the cost may be higher than the market is willing to bear for a disposable buy item.

**In** this regard, one of the issues with ICT is the cost and development time associated with the test fixture. These test fixtures, whose cost can range from $10,000 to over $100,000, are typically unique to the specific board being tested and cannot be used to test any other board types. As a result, while the manufacturer may have only one or two ICT systems on a manufacturing line, it is likely the manufacturer has purchased tens to hundreds of different test fixtures, many of which have become obsolete as a result of short product lifetimes.

DE 102015206000 describes a contact-distance transformer of an electric testing device for testing an electric specimen such as a wafer.

EP 1906189 A1 describes a probe card assembly for testing semiconductor devices.

US 2014/0253159 describes an electrical test interconnect method that employs a tester interface transfer block to enable the transfer of electrical contact from less accurate tester resource probes to target probes that are contained in the tester interface transfer block and can be positioned using three dimensional printing to enable reliable contact with smaller test pads.

US 2015/0137848 describes a system that includes a circuit board including electrical elements arranged at a first pitch, a wafer including contacts arranged at a second pitch, where the second pitch is less than the first pitch; and an interconnect including additively-manufactured electrical conduits that are part of an electrical pathway between the electrical elements and the contacts, where the additively-manufactured electrical conduits include electrically-conductive material.

### SUMMARY

An in-circuit test fixture according to the invention is defined in claim 1. A method of forming an in-circuit test fixture is defined in claim 13. Further embodiments are defined by the dependent claims.

The foregoing may reduce the cost of an ICT cell and also may reduce the time to construct an appropriate test fixture.

Any two or more of the features described in this specification, including in this summary section, can be combined to form implementations not specifically described herein.

The systems and techniques described herein, or portions thereof, can be implemented as/controlled by a computer program product that includes instructions that are stored on one or more non-transitory machine-readable storage media, and that are executable on one or more processing devices to control (e.g., coordinate) the operations described herein. The systems and techniques described herein, or portions thereof, can be implemented as an apparatus, method, or electronic system that can include one or more processing devices and computer memory to store executable instructions to implement various operations.

The details of one or more implementations are set forth in the accompanying drawings and the description below. Other features and advantages will be apparent from the description and drawings, and from the claims.

### DESCRIPTION OF THE DRAWINGS

Fig. 1 is a block diagram of an illustrative, related example test fixture that includes a top plate between an additively-manufactured structure and a UUT and that is outside the scope of the claims.
Fig. 2 is a block diagram of an illustrative, related example test fixture that includes a Z-axis anisotropic conductor between a top plate a UUT and that is outside the scope of the claims.
Fig. 3 is a block diagram of an example test fixture that includes contacts to a UUT directly on an additively-manufactured structure.
Fig. 4 is a block diagram of an example buried conductive structure.
Fig. 5 is a block diagram of an example hidden conductive structure.
Fig. 6 is a block diagram including an example diagonal conductive structure.
Fig. 7 is a flowchart showing an example process for forming an additively-manufactured test fixture.

### DETAILED DESCRIPTION

In-circuit test (ICT) may be used to identify manufacturing process defects and component defects on populated printed circuit board (PCB) assemblies. ICT systems (or simply, test systems) may obtain access to a unit under test (UUT), such as a PCB, through a test fixture (also called a test fixture interface). When performing electrical tests, active and passive components on a UUT are typically isolated from other surrounded components and tested on an individual basis. The PCB is configured to support this level of testability by incorporating test pads that can be contacted by corresponding electrical contacts on the test fixture.

The example test fixtures described herein provide the physical and electrical interface between the test system and the UUT - in the examples described herein, a PCB. The example test fixtures may be configured to route signals between test pins of the ICT system's receiver interface and test pad locations on the UUT.

The test fixtures may be produced using an additive manufacturing process, such as three-dimensional (3D) printing. For example, a test fixture may be, or include, an interface (called an interconnect or translator) that is additively-manufactured using co-printed dielectric material (e.g., electrically non-conductive material) and electrically-conductive material. The electrically-conductive (or, simply "conductive") material may include, but is not limited to, heavily-loaded silver particles in a thermoplastic or thermoset matrix. Silver and other noble metals may be used because their oxides, that may appear over time, are also conductive. Alternatively, conductive materials such as copper or copper alloys can be used. In cases where materials such as these are used, the additive manufacturing process may be performed in an inert atmosphere, such as Nitrogen (N₂), so that oxidation over time of the base conductive material is inhibited.

In some implementations, electrically non-conductive (or, simply "non-conductive") layers are printed on a base plate. The base plate may become part of the test fixture, or it may be removed, as described herein. In an example, the lower test fixture interface to the test system is implemented by the base plate. For example, the base plate may provide the mechanical and electrical foundation upon which layers of material may be added by additive manufacturing to form the test fixture. In some implementations, the base plate includes electrical contacts, that are configured and arranged to mate to corresponding electrical contacts on the ICT system (or test system) receiver and to mate to correspondingly arranged vias in the test fixture. Material forming the non-conductive parts of the test fixture interface is applied around electrical contacts on the base plate, and surrounds those contacts. Thereafter, conductive and non-conductive material is accumulated over the resulting structure, in layers, to form the test fixture. In some implementations, the base plate is used as an initial structure on which layers are accumulated, and is subsequently removed, with appropriate test system contacts added to, or formed in, the test fixture.

Electrical interconnection among multiple additively-manufactured layers may be implemented through inter-layer structures. Examples of such inter-layer structures include, but are not limited to, conductors, such as vias, which are formed in, or added to, the test fixture. In some cases, the vias can be "blind" (surface layer to inner layer), or "buried" (inner layer to inner layer). Transmission of signals, including high-speed or low-signal-level signals, may benefit from additively-manufactured conduits. That is, through additive manufacturing, conductors may be formed that are shielded, coaxial, and that have a controlled characteristic impedance. Signal transmission may be improved through use of conductors such as these.

In some implementations, the test fixture may be additively-manufactured directly upon target pads (or "brads") or cups, without using a base plate, as described herein, to support the test brads. As described above, in some implementations, a temporary unit (which may be a base plate or other type of apparatus) that is comprised of any appropriate rigid material may be used to mechanically retain the interface brads in place while the additive manufacturing (e.g., 3D printing) process begins. Once the printing, or at least a portion thereof, has been completed and the printed material has cured, the temporary unit can be removed and re-used for to form subsequent test fixtures.

In some implementations, test system POGO pins, which may be located in the test system receiver, directly connect to electrical contacts on the bottom of the test fixture. In some implementations, the electrical contacts on the bottom of the test fixture may be pads (or brads). These pads may be printed with thick, hard material in order to withstand the repeated contact force of the tester POGO pins. In some implementations, POGO pin receptacles may be used in place of pads.

In some implementations, the top of the test fixture includes an electrical path to POGO pins or other electrical contacts that ultimately mate to UUT test pads. The electrical contacts may be implemented in several ways, depending upon the process capabilities and cost targets of the manufacturer. In some implementations, thick pads are printed and may include gold, e.g., a hard gold finish, to promote improved electrical conductivity and resistance to oxidation that may otherwise negatively impact contact reliability. In some implementations, noble metals other than gold may be used.

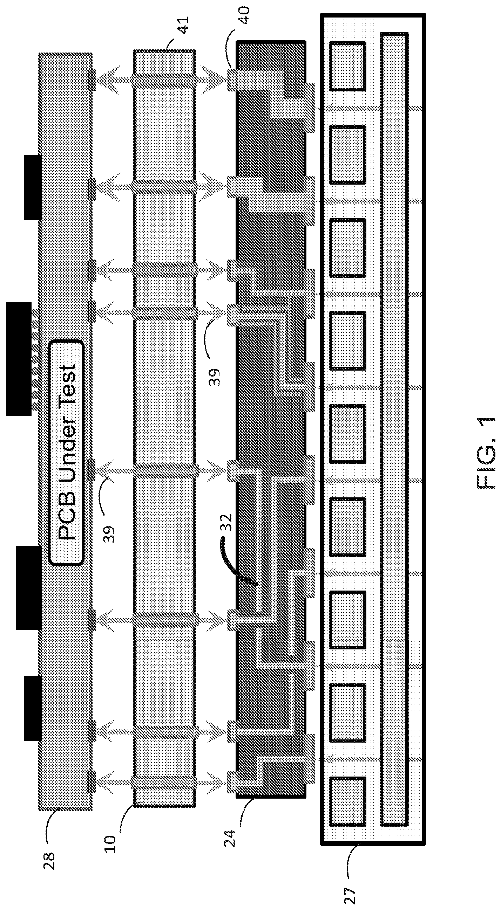

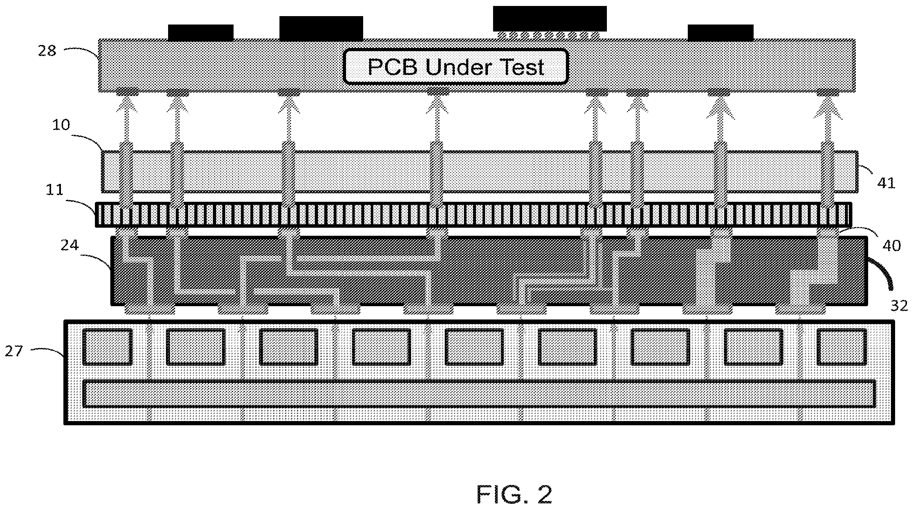

In some implementations, an interconnect vehicle between the test fixture and the UUT test pads may include a top plate 10 comprising a double sided POGO pin structure that is mechanically held in a fixed geographic location relative to the UUT (see, e.g., Fig. 1), or may include a Z-axis anisotropic conductor 11 that is arranged above the additively-manufactured structure and allows a single ended POGO pin, mounted in a receptacle, to facilitate the last section of interconnect to the UUT test pads (see, e.g., Fig. 2). The Z-axis conductor pad may be, or include, a flexible insulating rubber material that has a multiplicity of fine, closely-spaced metal wire conductors placed in the flexible insulating material. This material provides the compliancy that would otherwise have been provided by the lower half of a double-sided POGO pin.

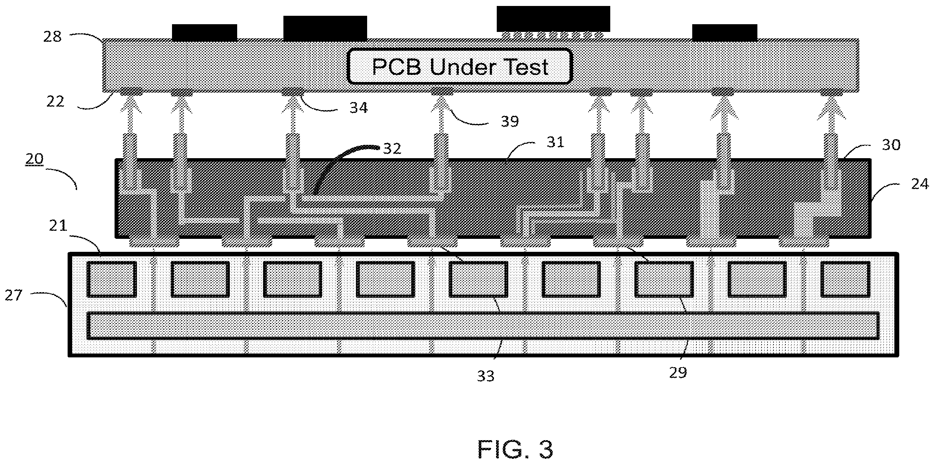

In some implementations, POGO pin receptacles that normally reside in a drilled POGO pin carrier can be temporarily held in place by a holder during additive manufacturing of the test fixture interface, allowing them to become a permanent part of the test fixture, rather than part of a carrier plate. This eliminates the cost of a carrier plate and the cost of the drilling holes in the carrier plate. An example implementation of such a test fixture to interface between a test system and a UUT, which may reduce both fixture cost and signal path length, is shown in Fig. 3.

Referring to Fig. 3, electrical connections between test pins of the test system's receiver interface and test pad locations on the UUT are implemented through conductive structures that are created, in whole or in part, through an additive manufacturing (e.g., 3D printing) process. In some implementations, the structures are only partly created through additive manufacturing, and may be incorporated into the substrate of a test fixture interface through other process(es). For example, metal may be added to holes in the substrate to create all or part of the conductive structures.

As explained, example structures include, but are not limited to, one or more vias that are electrically conductive. As noted, the substrate and structures in the substrate may be formed, in whole or in part, through accumulation of layers of material. During an example additive manufacturing process, layers are deposited, one on top of the other. Each layer may include conductive and non-conductive materials, arranged so as to form the substrate and structures, through accumulation of layers, at appropriate locations within the test fixture. As the layers are deposited, e.g., using a 3D printer or other appropriate additive manufacturing device, the type of material being deposited changes at appropriate locations. For example, in areas of a layer that are to be part of the substrate, non-conductive material is deposited, and in areas of the layer that are to be a conductive structure, conductive material is deposited.

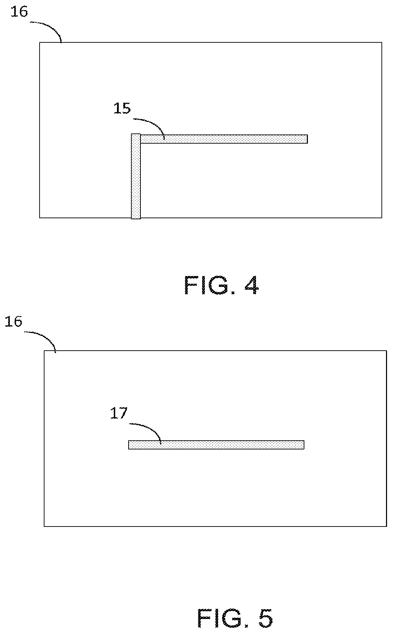

As in the examples described above, conductive structures can pass all the way through the test fixture in order to connect electrical contacts on the test system to electrical contacts on the UUT. In some cases, however, structures need not pass all the way through a fixture. For example, a blind structure may electrically connect one external electrical contact (such as a contact to the test system or to the UUT) to an internal conductive layer or structure. Fig. 4 shows an example blind structure 15 within a substrate 16 that is part of a test fixture interface. As shown, blind structure 15 does not pass all the way through the fixture and, thus, does not directly connect a contact on the test system to a contact on the UUT (an indirect connection, however, may result through an electrical pathway that includes the internal conductive layer). A hidden structure may electrically connect two internal conductive layers and/or structures. Fig. 5 shows an example of a hidden structure 17 within substrate 16.

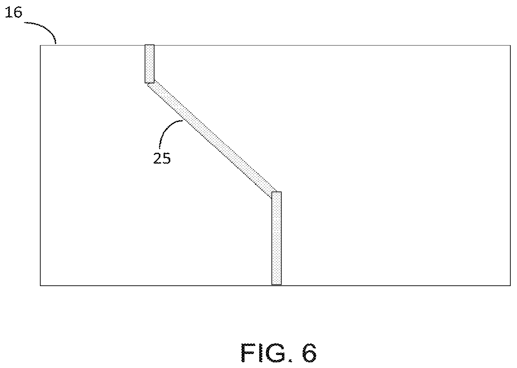

As noted, in some implementations, the conductive structures are vias. Some vias may be formed (e.g., printed) horizontally and vertically, as measured relative to the top plane 21 of the tester and the bottom plane 22 of the UUT, or as measured relative to the upper and lower surfaces of the substrate 24 that forms the test fixture 20 (see, e.g., Fig. 3). Some vias may be formed diagonally, and may contain one or more angles or undulating curves as measured relative to the top plane 21 of the tester and the bottom plane 22 of the UUT, or as measured relative to the upper and lower surfaces of the substrate 24 that forms the test fixture. The vias thus may also be, in whole or in part, non-vertical and/or non-horizontal. For example, Fig. 6 shows an example of a via 25 that is formed diagonally within a substrate 16 (which may be an example of, or part of, substrate 24) using additive manufacturing within an interface. Vias that are not limited to horizontal and vertical sections may provide a more direct conductive path between pins or other contacts on the tester and the UUT.

Referring to Fig. 3, in an example implementation, a test fixture 20 interfaces a tester 27 and a UUT 28. Test fixture 20 includes electrical contacts 29 that face the tester, and electrical contacts 30 that face the UUT. Test fixture 20 also includes substrate 24 comprised of sections of additively-manufactured, 3D-printed, non-conductive material 31 that is at least partly between electrical contacts 29 and electrical contacts 30. The non-conductive material provides rigidity, and supports the electrical contacts and the conductive structures (e.g., vias) that pass signals between the tester and the UUT. As noted, conductive structures 32 are formed by additive manufacturing, by 3D-printing, at appropriate times during formation of the substrate by switching the material used during printing, e.g., from the non-conductive material that forms the substrate to the conductive material that forms vias. In some implementations, this is done layer-by-layer, such that a single layer contains both conductive and non-conductive parts at appropriate locations which, when combined with upper and lower layers, additively form the vertical structures depicted in the figures. The test fixture thus includes conductive structures through the substrate, which are formed by accumulation of conductive material by 3D-printing. As shown, e.g., in Fig. 3, one or more of the conductive structures 32 electrically connects, e.g., provides an electrical pathway between one or more contacts 33 on test fixture 20 and one or more contacts 34 on the UUT. Connection between the UUT and the test fixture is depicted by arrows 39

In the example of Fig. 3, conductive structures 32 are vias that provide the electrical pathway between electrical contacts 29 - brads or pads, in this example - that provide interface to test fixture 20 and pins, e.g., POGO pins, that interface to the UUT. In some implementations, electrical contacts 29 and electrical contacts 30 - which are pin receptacles, in this example - may be part of the test fixture, e.g., the substrate and vias may be formed around the pin receptacles and brads, or the pin receptacles and brads may be inserted or implanted into the test fixture as described herein. For example, test fixture 20 may be formed with one or more brads and/or one or more pin receptacles to enable electrical between the test system and the UUT through conductive structures (e.g., vias) in the test fixture. As noted, the conductive structures may be formed of any appropriate conductive material, such as silver-based material.

In some implementations, one or more of the conductive structures (e.g., the vias) includes the conductive material surrounded, in whole or part, by a dielectric material, and the dielectric material is surrounded, in whole or part, by conductive material. That is, one or more of the vias may be coaxial, with the internal conductive material forming the signal path and a concentric outer material (with a dielectric between the two) forming the return path. Any appropriate dielectric may be used, such as air or the material otherwise used to form the non-conductive parts of the substrate.

As described above, a base plate may hold electrical contacts 29 to the test fixture. Sections of printed non-conductive material are formed on the base plate, and then the vias are formed to connect, electrically, to the contacts on the base plate. In some implementations, the base plate, aside from the electrical contacts thereon, is formed of a non-conductive material that is sufficiently rigid to support additive manufacturing thereon. The non-conductive material of the base plate may be the same as, or different from, the non-conductive material of the test fixture (the substrate).

In some implementations, a top plate holds the electrical contacts to the UUT. For example, the top plate may hold pin receptacles to which POGO pins on the UUT interface. The top plate may be attached to substrate 24 in any appropriate manner. For example, Fig. 1 shows pin receptacles on a top plate 10 that attaches to the printed structure comprising substrate 24 and conductive structures 32. The directions of attachments are shown by arrows 39. In the example of Fig. 1, the printed structure includes electrical contact pads (or brads) 40 also on its top, which interface to pins/pin receptacles 41 on the top plate. The contacts pads may be deposited contacts or otherwise formed. In this example, the test fixture thus may include the additively-manufactured structure, which contains the substrate, the brads, and the vias, along with the top plate 10. The remainder of the test fixture of Fig. 1 may be identical to, or similar to, the implementation of Fig. 3.

In some implementations, as shown in Fig. 2, there may be a Z-axis anisotropic conductor 11 between contact pads 40 and top plate 10. The z-axis anisotropic conductor 11 may be made of a conductive material and may route signals between contact pads 40 and pins/pin receptacles 41. The remainder of the test fixture of Fig. 2 may be identical to, or similar to, the implementation of Fig. 1.

Referring back to Fig. 3, in some implementations, electrical contacts (e.g., contact pads or pin receptacles) on the top of fixture 20 have a layout that corresponds to a layout of contacts on the UUT; and the electrical contacts (e.g., contact pads or pin receptacles) on the bottom of the test fixture have a layout that corresponds to a layout of contacts on part of the tester (e.g., the test system receiver). Configurations such as this facilitate connection between the tester, the test fixture, and the UUT.

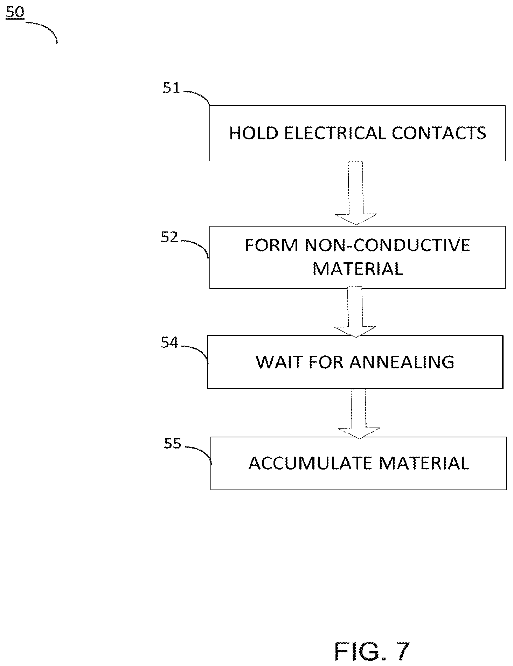

Referring to Fig. 7, an example process 50 for forming a test fixture, such as the examples shown in Figs. 1 to 6, includes forming a substrate and structures in the substrate at least in part through accumulation of sections (e.g., layers) of conductive and non-conductive material. That is, at least some of the sections of material include electrically non-conductive material that forms the substrate and electrically-conductive material that forms the structures (e.g., the vias). Example process 50 includes holding (51) electrical contacts to the UUT in place using a device, such as a base plate; forming (52) at least part of the non-conductive material around the electrical contacts; waiting (53) until the non-conductive material anneals; and removing the device or leaving it in place. That is, in some implementations, the device (e.g., the base plate) is left in place and becomes part of the test fixture. In examples such as this, the electrical contacts pass through the test plate to enable electrical connection between contacts on the tester and vias formed in the test fixture as described herein.

In any event, to form conductive and non-conductive parts of the test fixture, layers of conductive and/or non-conductive material are accumulated (54). Depending upon the structures that they are to form, individual layers may include non-conductive material only, a combination of conductive and non-conductive material, or conductive material only. In some implementations, the formation process includes forming conductive structures (e.g., vias) using a combination of accumulated material and other, added, conductive material. For example, a part of a via may be formed through additive manufacturing, and holes may be left in the substrate that connect to the formed part of the via. Conductive material may be added to the holes to complete formation of the via. In some implementations, the test fixture may include some vias formed solely by additive manufacturing, some vias formed by addition of metal to holes (e.g., by non-additive manufacturing processes), and some vias may be formed through a combination of additive manufacturing and non-additive manufacturing processes. Vias are connected to appropriate conductive pads to form electrical pathways.

In some implementations, electrical contacts (e.g., contact pad or pin receptacles) are arranged on the top of the fixture to have a layout that corresponds to a layout of contacts on the UUT; and the electrical contacts (e.g., pins or pins receptacles) are arranged on the bottom of the fixture to have a layout that corresponds to a layout of contacts on part of the tester. The electrical contacts on the top and/or the bottom of the fixture may be, or include, one or more of contact pads, contact pins, pin receptacles, or any other appropriate mechanism that enables formation of an electrical connection. Pin receptacles are configured to receive, and to hold, pins to create electrical contact. In some implementations, the contacts may be added by pressing or otherwise incorporating the contacts into a resulting printed fixture or substrate. In any event, vias through substrate connect contacts on the top and bottom of the fixture.

As explained above, in some implementations, one or more of the conductive structures (e.g., the vias) comprises the conductive material surrounded, at least in part, by a dielectric material, and the dielectric material surrounded, at least in part, by conductive material. This may be achieved, for example, through appropriate accumulation of material during formation by additive manufacturing.

In some implementations, process 50 may include attaching a top plate to the resulting test fixture. As described with respect to Fig. 1, the top plate may include contacts that create an electrical connection between the test fixture and contacts on the UUT. As described with respect to Fig. 2, the process may include incorporating a Z-axis conductor between the top plate and the additively-manufactured structure.

Test fixtures that utilize an additively-manufactured interface may be configured to support a range of interconnect paths, typically from as few as several hundred connections to as many as, e.g., 15,000, connections, and can help lower the recurring cost of in-circuit test cell on the manufacturer's PCB, or other, assembly line.

Testing performed by the example test system described herein may be implemented using hardware or a combination of hardware and software. For example, a test system like the ones described herein may include various controllers and/or processing devices located at various points in the system to control operation. A central computer may coordinate operation among the various controllers or processing devices.

The test system may be controlled by one or more computers, e.g., by sending signals to and from one or more wired and/or wireless connections to each test slot. The testing can be controlled, at least in part, using one or more computer program products, e.g., one or more computer program tangibly embodied in one or more non-transitory machine-readable media, for execution by, or to control the operation of, one or more data processing apparatus, e.g., a programmable processor, a computer, multiple computers, and/or programmable logic components.

A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or on multiple computers at one site or distributed across multiple sites and interconnected by a network.

Actions associated with implementing all or part of the testing can be performed by one or more programmable processors executing one or more computer programs to perform the functions described herein. All or part of the testing can be implemented using special purpose logic circuitry, e.g., an FPGA (field programmable gate array) and/or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only storage area or a random access storage area or both. Elements of a computer (including a server) may include one or more processors for executing instructions and one or more storage area devices for storing instructions and data. Generally, a computer will also include, or be operatively coupled to receive data from, or transfer data to, or both, one or more machine-readable storage media, such as mass storage devices for storing data, e.g., magnetic, magneto-optical disks, or optical disks. Machine-readable storage media suitable for embodying computer program instructions and data include all forms of non-volatile storage area, including by way of example, semiconductor storage area devices, e.g., EPROM, EEPROM, and flash storage area devices; magnetic disks, e.g., internal hard disks or removable disks; magneto-optical disks; and CD-ROM and DVD-ROM disks.

Any electrical connection involving transfer of signals may imply a direct physical connection or a wired or wireless connection that includes intervening components but that nevertheless allows electrical signals to flow between connected components. Any connection of electrical circuitry that enables signals to pass, unless stated otherwise, is an electrical connection and not necessarily a direct physical connection regardless of whether the word electrical is used to modify connection.

Elements of different implementations described herein may be combined to form other embodiments not specifically set forth above. Elements may be left out of the structures described herein without adversely affecting their operation. Furthermore, various separate elements may be combined into one or more individual elements to perform the functions described herein.

## Claims

1. An in-circuit test fixture for interfacing a tester and a unit under test, i.e., UUT, the test fixture comprising:
first electrical contacts (29) that face the tester;
second electrical contacts (30) that face the UUT, wherein the second electrical contacts (30) include preformed pin receptacles for holding pins configured to mate to contacts of the UUT;
a substrate (16, 24) comprised of sections of 3D-printed first material (31), the 3D-printed first material being electrically non-conductive, the substrate being between the first electrical contacts and the second electrical contacts, the 3D-printed first material formed around the pin receptacles such that the pin receptacles are implanted in the test fixture; and
conductive structures (25, 32) through the substrate, the conductive structures formed by 3D-printing of second material, the second material being electrically conductive, the conductive structures electrically connecting respective of the first electrical contacts and respective of the second electrical contacts.

2. The in-circuit test fixture of claim 1, wherein at least one of the structures within the substrate has a section that is non-vertical and non-horizontal relative to upper and lower surfaces of the substrate.

3. The in-circuit test fixture of claim 1, wherein the 3D-printed first material surrounds, and is in contact with, at least part of the first electrical contacts.

4. The in-circuit test fixture of claim 1, wherein the pin receptacles are POGO pin receptacles.

5. The in-circuit test fixture of claim 1, wherein the first electrical contacts comprise sections of printed third material, the printed third material being electrically conductive and comprising a noble metal.

6. The in-circuit test fixture of claim 1, wherein at least one of the structures comprises the second material surrounded, at least in part, by a dielectric material, the dielectric material being surrounded, at least in part, by conductive material.

7. The in-circuit test fixture of claim 1, further comprising:
a top plate (10) holding the first electrical contacts, the top plate being attached to the substrate.

8. The in-circuit test fixture of claim 1, wherein the second electrical contacts have a layout that corresponds to a layout of contacts on the UUT; and
wherein the first electrical contacts have a layout that corresponds to a layout of contacts on part of the tester.

9. The in-circuit test fixture of claim 1, further comprising an inter-layer via structure formed in, or added to, the test fixture and configured to implement electrical interconnection among multiple 3D-printed layers.

10. The in-circuit test fixture of claim 9, wherein the inter-layer via structure is blind (15) and configured to implement electrical interconnection among a surface layer and an inner layer.

11. The in-circuit test fixture of claim 9, wherein the inter-layer via structure is buried (17) and configured to implement electrical interconnection among inner layers.

12. The in-circuit test fixture of any preceding claim, wherein the UUT is a printed circuit board.

13. A method of forming an in-circuit test fixture for interfacing a tester and a unit under test, i.e., UUT, the method comprising:
forming a substrate (16, 24) and structures (25, 32) in the substrate at least in part through accumulation of sections of 3D-printed material, at least some of the sections of 3D-printed material comprising electrically non-conductive material that forms the substrate and electrically-conductive material that forms the structures;
wherein the substrate is to be between first electrical contacts (29) and second electrical contacts (30), the first electrical contacts facing the tester, and the second electrical contacts facing the UUT, at least one of the structures being formed to electrically connect a respective of the first electrical contacts and a respective of the second electrical contacts,
wherein forming the substrate comprises
holding the second electrical contacts in place using an apparatus,
forming at least part of at least one of the sections around the second electrical contacts,
waiting until the at least part of at least one of the sections anneals, and
removing the apparatus with the second electrical contacts becoming part of the in-circuit test fixture and implanted in the test fixture.

14. The method of claim 13, wherein at least one of the structures within the substrate is formed to have a section that is non-vertical and non-horizontal relative to upper and lower surfaces of the substrate.

15. The method of claim 13, wherein the second electrical contacts comprise POGO pin receptacles.

16. The method of claim 13, wherein the first electrical contacts are formed through the accumulation of the sections of material, at least some of the sections comprising electrically-conductive material that forms the first electrical contacts.

17. The method of claim 13, further comprising:
arranging the second electrical contacts to have a layout that corresponds to a layout of contacts on the UUT; and
arranging the first electrical contacts to have a layout that corresponds to a layout of contacts on part of the tester.

18. The method of claim 13, wherein at least one of the structures is formed of the electrically-conductive material surrounded, at least in part, by a dielectric material, the dielectric material being surrounded, at least in part, by another electrically-conductive material.

## Patentansprüche

1. Schaltungsinterne Testvorrichtung zum Verbinden eines Testers und einer zu prüfenden Einheit, d. h. UUT (Unit Under Test), wobei die Testvorrichtung Folgendes umfasst:
erste elektrische Kontakte (29), die dem Tester zugewandt sind;
zweite elektrische Kontakte (30), die der UUT zugewandt sind, wobei die zweiten elektrischen Kontakte (30) vorgeformte Stiftaufnahmen zum Halten von Stiften beinhalten, die dazu ausgelegt sind, mit Kontakten der UUT zusammenzupassen;
ein Substrat (16, 24), das Abschnitte aus 3D-gedrucktem ersten Material (31) umfasst, wobei das 3D-gedruckte erste Material elektrisch nicht leitfähig ist, wobei sich das Substrat zwischen den ersten elektrischen Kontakten und den zweiten elektrischen Kontakten befindet, wobei das 3D-gedruckte erste Material um die Stiftaufnahmen herum gebildet ist, so dass die Stiftaufnahmen in die Testvorrichtung implantiert sind; und
leitfähige Strukturen (25, 32) durch das Substrat hindurch, wobei die leitfähigen Strukturen durch 3D-Drucken eines zweiten Materials gebildet werden, wobei das zweite Material elektrisch leitfähig ist, wobei die leitfähigen Strukturen jeweilige der ersten elektrischen Kontakte und jeweilige der zweiten elektrischen Kontakte elektrisch verbinden.

2. Schaltungsinterne Testvorrichtung nach Anspruch 1, wobei mindestens eine der Strukturen innerhalb des Substrats einen Abschnitt aufweist, der relativ zur oberen und unteren Oberfläche des Substrats nicht vertikal und nicht horizontal ist.

3. Schaltungsinterne Testvorrichtung nach Anspruch 1, wobei das 3D-gedruckte erste Material zumindest einen Teil der ersten elektrischen Kontakte umgibt und mit diesen in Kontakt steht.

4. Schaltungsinterne Testvorrichtung nach Anspruch 1, wobei die Stiftaufnahmen POGO-Stiftaufnahmen sind.

5. Schaltungsinterne Testvorrichtung nach Anspruch 1, wobei die ersten elektrischen Kontakte Abschnitte aus gedrucktem dritten Material umfassen, wobei das gedruckte dritte Material elektrisch leitfähig ist und ein Edelmetall umfasst.

6. Schaltungsinterne Testvorrichtung nach Anspruch 1, wobei mindestens eine der Strukturen das zweite Material umfasst, das zumindest teilweise von einem dielektrischen Material umgeben ist, wobei das dielektrische Material zumindest teilweise von leitfähigem Material umgeben ist.

7. Schaltungsinterne Testvorrichtung nach Anspruch 1, ferner umfassend:
eine obere Platte (10), die die ersten elektrischen Kontakte hält, wobei die obere Platte an dem Substrat angebracht ist.

8. Schaltungsinterne Testvorrichtung nach Anspruch 1, wobei die zweiten elektrischen Kontakte ein Layout aufweisen, das einem Layout von Kontakten auf der UUT entspricht; und
wobei die ersten elektrischen Kontakte ein Layout aufweisen, das einem Layout von Kontakten auf einem Teil des Testers entspricht.

9. Schaltungsinterne Testvorrichtung nach Anspruch 1, ferner umfassend eine Inter-Schicht-Via-Struktur, die in der Testvorrichtung gebildet oder zu dieser hinzugefügt ist und dazu ausgelegt ist, eine elektrische Zwischenverbindung zwischen mehreren 3D-gedruckten Schichten zu implementieren.

10. Schaltungsinterne Testvorrichtung nach Anspruch 9, wobei die Inter-Schicht-Via-Struktur blind (15) ist und dazu ausgelegt ist, eine elektrische Zwischenverbindung zwischen einer Oberflächenschicht und einer Innenschicht zu implementieren.

11. Schaltungsinterne Testvorrichtung nach Anspruch 9, wobei die Inter-Schicht-Via-Struktur vergraben ist (17) und dazu ausgelegt ist, eine elektrische Zwischenverbindung zwischen inneren Schichten zu implementieren.

12. Schaltungsinterne Testvorrichtung nach einem der vorhergehenden Ansprüche, wobei die UUT eine Leiterplatte ist.

13. Verfahren zum Bilden einer schaltungsinternen Testvorrichtung zum Verbinden eines Testers und einer zu prüfenden Einheit, d. h. UUT (Unit Under Test), wobei das Verfahren Folgendes umfasst:
Bilden eines Substrats (16, 24) und von Strukturen (25, 32) in dem Substrat zumindest teilweise durch Akkumulation von Abschnitten aus 3D-gedrucktem Material, wobei zumindest einige der Abschnitte aus 3D-gedrucktem Material elektrisch nicht leitfähiges Material, das das Substrat bildet, und elektrisch leitfähiges Material, das die Strukturen bildet, umfassen;
wobei das Substrat zwischen ersten elektrischen Kontakten (29) und zweiten elektrischen Kontakten (30) sein soll, wobei die ersten elektrischen Kontakte dem Tester zugewandt sind und die zweiten elektrischen Kontakte der UUT zugewandt sind, wobei mindestens eine der Strukturen ausgebildet ist, um einen jeweiligen der ersten elektrischen Kontakte und einen jeweiligen der zweiten elektrischen Kontakte elektrisch zu verbinden,
wobei das Bilden des Substrats Folgendes umfasst:
Halten der zweiten elektrischen Kontakte unter Verwendung einer Einrichtung an Ort und Stelle,
Bilden zumindest eines Teils mindestens eines der Abschnitte um die zweiten elektrischen Kontakte herum,
Warten, bis der zumindest Teil mindestens eines der Abschnitte härtet, und
Entfernen der Einrichtung, wobei die zweiten elektrischen Kontakte Teil der schaltungsinternen Testvorrichtung werden und in die Testvorrichtung implantiert werden.

14. Verfahren nach Anspruch 13, wobei mindestens eine der Strukturen innerhalb des Substrats so ausgebildet ist, dass sie einen Abschnitt aufweist, der relativ zur oberen und unteren Oberfläche des Substrats nicht vertikal und nicht horizontal ist.

15. Verfahren nach Anspruch 13, wobei die zweiten elektrischen Kontakte POGO-Stiftaufnahmen umfassen.

16. Verfahren nach Anspruch 13, wobei die ersten elektrischen Kontakte durch die Akkumulation der Abschnitte von Material gebildet werden, wobei zumindest einige der Abschnitte elektrisch leitfähiges Material umfassen, das die ersten elektrischen Kontakte bildet.

17. Verfahren nach Anspruch 13, ferner umfassend:
Anordnen der zweiten elektrischen Kontakte, so dass sie ein Layout aufweisen, das einem Layout von Kontakten auf der UUT entspricht; und
Anordnen der ersten elektrischen Kontakte, so dass sie ein Layout aufweisen, das einem Layout von Kontakten auf einem Teil des Testers entspricht.

18. Verfahren nach Anspruch 13, wobei mindestens eine der Strukturen aus dem elektrisch leitfähigen Material gebildet ist, das zumindest teilweise von einem dielektrischen Material umgeben ist, wobei das dielektrische Material zumindest teilweise von einem anderen elektrisch leitfähigen Material umgeben ist.

## Revendications

1. Dispositif de test in situ permettant de relier un testeur et une unité testée, UUT, le dispositif de test comprenant :
des premiers contacts électriques (29) qui font face au testeur ;
des seconds contacts électriques (30) qui font face à l'UUT, les seconds contacts électriques (30) comportant des réceptacles de broches préformés permettant de maintenir des broches configurées pour s'accoupler à des contacts de l'UUT ;
un substrat (16, 24) constitué de sections de premier matériau imprimé en 3D (31), le premier matériau imprimé en 3D étant électriquement non conducteur, le substrat étant situé entre les premiers contacts électriques et les seconds contacts électriques, le premier matériau imprimé en 3D étant formé autour des réceptacles de broches de telle sorte que les réceptacles de broches soient implantés dans le dispositif de test ; et
des structures conductrices (25, 32) à travers le substrat, les structures conductrices étant formées par impression 3D d'un second matériau, le second matériau étant électriquement conducteur, les structures conductrices reliant électriquement un contact respectif des premiers contacts électriques et un contact respectif des seconds contacts électriques.

2. Dispositif de test in situ selon la revendication 1, dans lequel au moins l'une des structures à l'intérieur du substrat a une section qui est non verticale et non horizontale par rapport aux surfaces supérieure et inférieure du substrat.

3. Dispositif de test in situ selon la revendication 1, dans lequel le premier matériau imprimé en 3D entoure, et est en contact avec, au moins une partie des premiers contacts électriques.

4. Dispositif de test in situ selon la revendication 1, dans lequel les réceptacles de broches sont des réceptacles de broches POGO.

5. Dispositif de test in situ selon la revendication 1, dans lequel les premiers contacts électriques comprennent des sections de troisième matériau imprimé, le troisième matériau imprimé étant électriquement conducteur et comprenant un métal noble.

6. Dispositif de test in situ selon la revendication 1, dans lequel au moins l'une des structures comprend le second matériau entouré, au moins en partie, par un matériau diélectrique, le matériau diélectrique étant entouré, au moins en partie, par un matériau conducteur.

7. Dispositif de test in situ selon la revendication 1, comprenant en outre :
une plaque supérieure (10) maintenant les premiers contacts électriques, la plaque supérieure étant fixée au substrat.

8. Dispositif de test in situ selon la revendication 1, dans lequel les seconds contacts électriques ont une disposition qui correspond à une disposition de contacts sur l'UUT ; et
dans lequel les premiers contacts électriques ont une disposition qui correspond à une disposition des contacts sur une partie du testeur.

9. Dispositif de test in situ selon la revendication 1, comprenant en outre une structure de trous d'interconnexion intercouches formée dans le dispositif de test, ou ajoutée à celui-ci, et configurée pour réaliser une interconnexion électrique entre de multiples couches imprimées en 3D.

10. Dispositif de test in situ selon la revendication 9, dans lequel la structure de trous d'interconnexion intercouches est borgne (15) et configurée pour réaliser une interconnexion électrique entre une couche de surface et une couche interne.

11. Dispositif de test in situ selon la revendication 9, dans lequel la structure de trous d'interconnexion intercouches est noyée (17) et configurée pour réaliser une interconnexion électrique entre des couches internes.

12. Dispositif de test in situ selon l'une quelconque des revendications précédentes, dans lequel l'UUT est une carte de circuit imprimé.

13. Procédé de formation d'un dispositif de test in situ permettant de relier un testeur et une unité testée, UUT, le procédé comprenant :
la formation d'un substrat (16, 24) et de structures (25, 32) dans le substrat au moins en partie par accumulation de sections de matériau imprimé en 3D, au moins une partie des sections de matériau imprimé en 3D comprenant du matériau électriquement non conducteur qui forme le substrat et du matériau électriquement conducteur qui forme les structures ;
le substrat étant destiné à se trouver entre des premiers contacts électriques (29) et des seconds contacts électriques (30), les premiers contacts électriques étant en regard du testeur et les seconds contacts électriques étant en regard de l'UUT, au moins l'une des structures étant formée pour relier électriquement un contact respectif des premiers contacts électriques et un contact respectif des seconds contacts électriques,
la formation du substrat comprenant
le maintien en place des seconds contacts électriques à l'aide d'un appareil,
la formation d'au moins une partie d'au moins l'une des sections autour des seconds contacts électriques,
l'attente jusqu'à ce que l'au moins une partie d'au moins une des sections ait subi un recuit, et
le retrait de l'appareil, les seconds contacts électriques faisant maintenant partie du dispositif de test in situ et étant implantés dans le dispositif de test.

14. Procédé selon la revendication 13, dans lequel au moins l'une des structures à l'intérieur du substrat est formée de manière à avoir une section qui est non verticale et non horizontale par rapport aux surfaces supérieure et inférieure du substrat.

15. Procédé selon la revendication 13, dans lequel les seconds contacts électriques comprennent des réceptacles de broches POGO.

16. Procédé selon la revendication 13, dans lequel les premiers contacts électriques sont formés par l'accumulation des sections de matériau, au moins certaines des sections comprenant un matériau électriquement conducteur qui forme les premiers contacts électriques.

17. Procédé de la revendication 13, comprenant en outre :
le positionnement des seconds contacts électriques de manière qu'ils aient une disposition qui correspond à une disposition de contacts sur l'UUT ; et
le positionnement des premiers contacts électriques de manière qu'ils aient une disposition qui correspond à une disposition des contacts sur une partie du testeur.

18. Procédé selon la revendication 13, dans lequel au moins l'une des structures est formée du matériau électriquement conducteur entouré, au moins en partie, par un matériau diélectrique, le matériau diélectrique étant entouré, au moins en partie, par un autre matériau électriquement conducteur.
